# EUROPEAN PATENT APPLICATION

(11) **EP 4 757 501 A1**
(43) Date of publication of application: **10.06.2026**
(21) Application number: 25217482.6
(22) Date of filing: 20.11.2025
(51) Int. Cl.: H05K 1/02, H05K 1/185, H05K 3/46, H10W 40/20, H10W 40/47

(54) **MULTI-LAYER CIRCUIT BOARD HAVING EMBEDDED BOARD-TYPE CHIP AND MANUFACTURING METHOD THEREFOR**

(30) Priority: 05.12.2024 CN 202411785895
(71) Applicant: ZF Friedrichshafen AG, 88046 Friedrichshafen (DE)
(72) Inventor: XU, Qing, Shanghai, 201615 (CN); YUAN, George, Shanghai, 201615 (CN)
(74) Representative: Nowack, Linda

(57) **Abstract**

The present disclosure relates to the technical field of vehicle parts and components, and provides a multi-layer board-type chip-embedded circuit board and a manufacturing method therefor. The multi-layer board-type chip-embedded circuit board includes: a prefabricated circuit board; a chip packaging unit embedded in the prefabricated circuit board; and a plurality of groups of first conductive modules stacked below the prefabricated circuit board, the plurality of groups of first conductive modules being provided with a slot from which the chip packaging unit is exposed, such that a heat dissipation cavity is formed between a back surface of the chip packaging unit and the slot, and the heat dissipation cavity is filled with an auxiliary heat dissipation material that is in contact with the chip packaging unit and the plurality of groups of first conductive modules. According to the present disclosure, by stacking the plurality of groups of first conductive modules below the prefabricated circuit board in which the chip packaging unit is embedded, the signal transmission capability can be greatly enhanced, and the stable operation of the circuit board and stable transmission of electrical signals are ensured; and heat generated during the operation of the chip packaging unit and the first conductive modules is quickly taken away by means of the auxiliary heat dissipation material filled in the heat dissipation cavity, thereby achieving effective heat dissipation.

## Description

### TECHNICAL FIELD

The present disclosure relates to the technical field of vehicle parts and components, and in particular to a multi-layer board-type chip-embedded circuit board and a manufacturing method therefor.

### BACKGROUND OF THE INVENTION

In vehicle inverters, the design of a chip-embedded circuit board is used to improve the integration level of the circuit board.

As the integration level increases, heat generated by electronic components in the circuit board becomes more concentrated, and how to effectively dissipate heat is a major problem. In addition, the inverters have a function of converting direct current into alternate current to drive the operation of a motor, and how to ensure the stable transmission of the electrical signals of the circuit board applied to the inverters to achieve stable drive of the motor is a problem that needs to be solved.

It should be noted that information disclosed in the above background art section is only used to enhance the understanding of the background of the present disclosure, and therefore may include information that does not constitute the prior art known to those of ordinary skill in the art.

### SUMMARY OF THE INVENTION

In view of this, the present disclosure provides a multi-layer board-type chip-embedded circuit board and a manufacturing method therefor. By stacking a plurality of groups of first conductive modules below a prefabricated circuit board in which a chip packaging unit is embedded, the signal transmission capability can be greatly enhanced, and the stable operation of the circuit board and stable transmission of electrical signals are ensured. In addition, a heat dissipation cavity between the first conductive modules and the chip packaging unit is filled with auxiliary heat dissipation materials, which can quickly take away heat generated during the operation of the chip packaging unit and the first conductive modules, thereby achieving effective heat dissipation.

According to one aspect of the present disclosure, a multi-layer board-type chip-embedded circuit board is provided, the multi-layer circuit board including: a prefabricated circuit board; a chip packaging unit embedded in the prefabricated circuit board; and a plurality of groups of first conductive modules stacked below the prefabricated circuit board, the plurality of groups of first conductive modules being provided with a slot from which the chip packaging unit is exposed, such that a heat dissipation cavity is formed between a back surface of the chip packaging unit and the slot, and the heat dissipation cavity is filled with an auxiliary heat dissipation material that is in contact with the chip packaging unit and the plurality of groups of first conductive modules.

In some embodiments, the auxiliary heat dissipation material is a thermally conductive adhesive, and the thermally conductive adhesive is flush with a bottommost film layer in the plurality of groups of first conductive modules.

In some embodiments, the slot is connected to a cooling apparatus, the cooling apparatus seals the heat dissipation cavity, and the auxiliary heat dissipation material is cooling oil that circulates and fills the heat dissipation cavity.

In some embodiments, heat dissipation fins are provided on the back surface of the chip packaging unit, and the auxiliary heat dissipation material fills a gap between the heat dissipation fins.

In some embodiments, the plurality of groups of first conductive modules include two groups, where each group of first conductive modules includes a first dielectric layer and a first conductive layer, and first dielectric layers and first conductive layers in the two groups of first conductive modules are alternately stacked.

In some embodiments, the multi-layer board-type chip-embedded circuit board further includes: a plurality of groups of second conductive modules stacked above the prefabricated circuit board, where each group of second conductive modules includes a second dielectric layer and a second conductive layer, and second dielectric layers and second conductive layers in the plurality of groups of second conductive modules are alternately stacked; and electrode lead-out wires led out from a front side of the chip packaging unit to a surface of the plurality of groups of second conductive modules, the electrode lead-out wires including vertical strip-shaped lead-out wires formed in the second dielectric layer and horizontal strip-shaped lead-out wires formed in the second conductive layer, where each electrode of the chip packaging unit is led out through at least one vertical strip-shaped lead-out wire, and each horizontal strip-shaped lead-out wire is connected to vertical strip-shaped lead-out wires that lead out one or more electrodes.

In some embodiments, the plurality of groups of second conductive modules include two groups, and two chip packaging units are embedded at an interval in the prefabricated circuit board, where a drain of a first chip packaging unit is led out sequentially through a group of vertical strip-shaped lead-out wires located in a lower second dielectric layer, a horizontal strip-shaped lead-out wire located in the lower second conductive layer, a group of vertical strip-shaped lead-out wires located in an upper second dielectric layer, and a horizontal strip-shaped lead-out wire located in the upper second conductive layer; a gate of the first chip packaging unit is led out through a vertical strip-shaped lead-out wire that passes through the lower second dielectric layer, the lower second conductive layer, the upper second dielectric layer, and the upper second conductive layer; a source of the first chip packaging unit is led out through a group of vertical strip-shaped lead-out wires located in the lower second dielectric layer, a drain of a second chip packaging unit is led out through a group of vertical strip-shaped lead-out wires located in the lower second dielectric layer, the vertical strip-shaped lead-out wires leading out the source of the first chip packaging unit and the vertical strip-shaped lead-out wires leading out the drain of the second chip packaging unit are connected through a horizontal strip-shaped lead-out wire located in the lower second conductive layer, and are led out through a group of vertical strip-shaped lead-out wires located in the upper second dielectric layer and a horizontal strip-shaped lead-out wire located in the upper second conductive layer; a source of the second chip packaging unit is led out sequentially through a group of vertical strip-shaped lead-out wires located in the lower second dielectric layer, a horizontal strip-shaped lead-out wire located in the lower second conductive layer, a group of vertical strip-shaped lead-out wires located in the upper second dielectric layer, and a horizontal strip-shaped lead-out wire located in the upper second conductive layer; and a gate of the second chip packaging unit is led out through a vertical strip-shaped lead-out wire that passes through the lower second dielectric layer, the lower second conductive layer, the upper second dielectric layer, and the upper second conductive layer.

In some embodiments, among all conductive layers, the lower second conductive layer has a largest thickness.

According to still another aspect of the present disclosure, a manufacturing method for a multi-layer board-type chip-embedded circuit board is provided, which is used for manufacturing a multi-layer board-type chip-embedded circuit board according to any one of the above embodiments, the manufacturing method including: providing a prefabricated circuit board; embedding a chip packaging unit in the prefabricated circuit board; stacking a plurality of groups of first conductive modules below the prefabricated circuit board, and providing a slot in the plurality of groups of first conductive modules to expose the chip packaging unit, such that a heat dissipation cavity is formed between a back surface of the chip packaging unit and the slot; and filling an auxiliary heat dissipation material in the heat dissipation cavity, such that the auxiliary heat dissipation material comes into contact with the chip packaging unit and the plurality of groups of first conductive modules.

In some embodiments, the manufacturing method further includes: alternately stacking second dielectric layers and second conductive layers above the prefabricated circuit board to form a plurality of groups of second conductive modules; and forming electrode lead-out wires in the plurality of groups of second conductive modules, to lead out an electrode of the chip packaging unit to a surface of the plurality of groups of second conductive modules, the electrode lead-out wires including vertical strip-shaped lead-out wires formed in the second dielectric layer and horizontal strip-shaped lead-out wires formed in the second conductive layer, where each electrode of the chip packaging unit is led out through at least one vertical strip-shaped lead-out wire, and each horizontal strip-shaped lead-out wire is connected to vertical strip-shaped lead-out wires that lead out one or more electrodes.

Compared with the prior art, the present disclosure has at least the following beneficial effects.

According to the present disclosure, by stacking the plurality of groups of first conductive modules below the prefabricated circuit board in which the chip packaging unit is embedded, the plurality of groups of first conductive modules may be used respectively as functional film layers such as a signal enhancement layer, an impedance control layer, an electromagnetic interference shielding layer, etc., thus greatly enhancing the signal transmission capability of the circuit board, and ensuring the stable operation of the circuit board and stable transmission of electrical signals; and the plurality of groups of first conductive modules can also enhance the mechanical strength of the circuit board and prolong the service life of the circuit board, so that the circuit board adapts to the usage scenarios of a vehicle inverter.

The slot from which the chip packaging unit is exposed is provided in the plurality of groups of first conductive modules, and the heat dissipation cavity between the back surface of the chip packaging unit and the slot is filled with the auxiliary heat dissipation material that is in contact with the chip packaging unit and the plurality of groups of first conductive modules, such that heat generated during the operation of the chip packaging unit and the first conductive modules can be rapidly dissipated through the auxiliary heat dissipation material, achieving effective heat dissipation, so that the circuit board adapts to large current operating conditions of a vehicle inverter and is applicable to usage scenarios that require strict compatibility with/adaptability to the inverter.

It should be understood that the above general description and the following detailed description are only exemplary and explanatory, and cannot limit the present disclosure.

### BRIEF DESCRIPTION OF DRAWINGS

The accompanying drawings herein, which are incorporated into and constitute a part of the description, illustrate embodiments consistent with the present disclosure and, together with the description, are used to explain principles of the present disclosure. Obviously, the accompanying drawings described below show merely some of the embodiments of the present disclosure, and those of ordinary skill in the art would also have obtained other accompanying drawings according to these accompanying drawings without any creative effort.
FIG. 1 is a schematic diagram of a sectional structure of a multi-layer board-type chip-embedded circuit board according to an embodiment of the present disclosure;
FIG. 2 is a schematic diagram of a sectional structure of another multi-layer board-type chip-embedded circuit board according to an embodiment of the present disclosure;
FIG. 3 is a schematic diagram of steps of a manufacturing method for a multi-layer board-type chip-embedded circuit board according to an embodiment of the present disclosure; and
FIG. 4 is a schematic diagram of steps of another manufacturing method for a multi-layer board-type chip-embedded circuit board according to an embodiment of the present disclosure.

### DETAILED DESCRIPTION OF THE INVENTION

Now exemplary implementations will be described more fully with reference to the accompanying drawings. However, the exemplary implementations can be implemented in many forms and should not be construed as being limited to the implementations described herein. On the contrary, these implementations are provided to make the present disclosure more thorough and complete, and to fully convey the concept of the exemplary implementations to those skilled in the art.

The accompanying drawings are only schematic illustrations of the present disclosure, and are not necessarily drawn to scale. In the accompanying drawings, the same reference numerals denote the same or similar parts, and thus the repeated description thereof will be omitted. The processes shown in the accompanying drawings are only exemplary illustrations, and do not necessarily include all steps. For example, some steps can be divided, and some steps can be combined or partially combined, and the actual execution order thereof may be changed based on actual conditions.

The terms "first", "second" and similar terms used in the specific description do not denote any order, quantity, or importance, but are merely used to distinguish between different components. Orientations or positional relationships indicated by the terms such as "upper" and "lower" are based on orientations or positional relationships shown in the accompanying drawings, which is only for convenience of describing the present disclosure and simplifying the description, rather than indicating or implying that an apparatus or an element referred to must have a specific orientation or be constructed and operated in a specific orientation, and therefore cannot be construed as limiting the present disclosure. The term "a plurality of" means two or more, unless otherwise explicitly and specifically defined. Moreover, in the description of the present disclosure, when it is said that a device is "connected" to another device, this includes not only the case of direct connection but also the case of indirect connection through other elements.

It should be noted that the embodiments in the present disclosure and features of the various embodiments can be combined with each other without conflict.

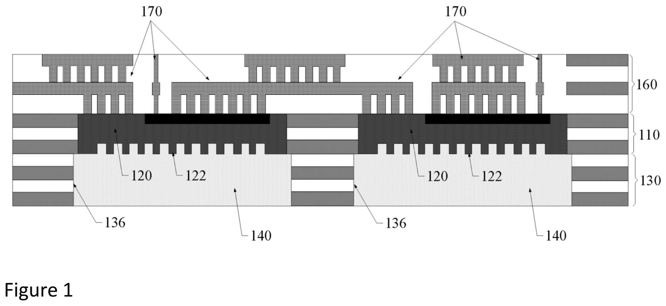

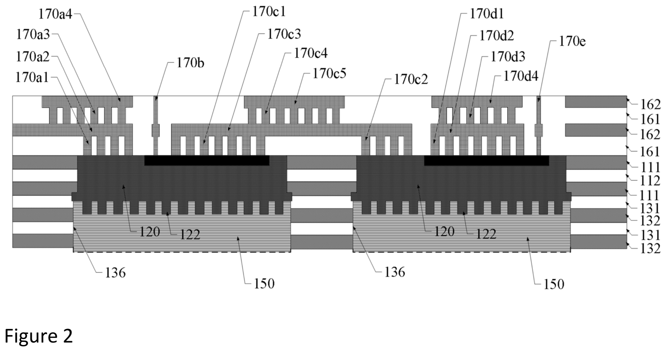

FIG. 1 illustrates a sectional structure of a multi-layer board-type chip-embedded circuit board, and FIG. 2 illustrates a sectional structure of another multi-layer board-type chip-embedded circuit board. With reference to FIG. 1 and FIG. 2, the multi-layer board-type chip-embedded circuit board according to an embodiment of the present disclosure includes:
a prefabricated circuit board 110;
a chip packaging unit 120, embedded in the prefabricated circuit board 110; and
a plurality of groups of first conductive modules 130 stacked below the prefabricated circuit board 110, the plurality of groups of first conductive modules 130 being provided with a slot from which the chip packaging unit 120 is exposed, such that a heat dissipation cavity 136 is formed between a back surface of the chip packaging unit 120 and the slot, and the heat dissipation cavity 136 is filled with an auxiliary heat dissipation material that is in contact with the chip packaging unit 120 and the plurality of groups of first conductive modules 130.

According to the present disclosure, by stacking the plurality of groups of first conductive modules 130 below the prefabricated circuit board 110 in which the chip packaging unit 120 is embedded, the plurality of groups of first conductive modules 130 may be used respectively as functional film layers such as a signal enhancement layer, an impedance control layer, an electromagnetic interference shielding layer, etc., thus greatly enhancing the signal transmission capability of the circuit board, and ensuring the stable operation of the circuit board and stable transmission of electrical signals; and the plurality of groups of first conductive modules 130 can also enhance the mechanical strength of the circuit board and prolong the service life of the circuit board, so that the circuit board adapts to the usage scenarios of a vehicle inverter.

The slot from which the chip packaging unit 120 is exposed is provided in the plurality of groups of first conductive modules 130, and the heat dissipation cavity 136 between the back surface of the chip packaging unit 120 and the slot is filled with the auxiliary heat dissipation material that is in contact with the chip packaging unit 120 and the plurality of groups of first conductive modules 130, such that heat generated during the operation of the chip packaging unit 120 and the first conductive modules 130 can be rapidly dissipated through the auxiliary heat dissipation material, achieving effective heat dissipation, so that the circuit board adapts to large current operating conditions of a vehicle inverter and is applicable to usage scenarios that require strict compatibility with/adaptability to the inverter.

In some embodiments, the auxiliary heat dissipation material is a thermally conductive adhesive 140 shown in FIG. 1, and the thermally conductive adhesive 140 is flush with a bottommost film layer in the plurality of groups of first conductive modules 130. The thermally conductive adhesive 140 may be uniformly applied to a sidewall of the slot of the plurality of groups of first conductive modules 130 and the back surface of the chip packaging unit 120 through a dispensing technique, until the heat dissipation cavity 136 is filled up, thereby achieving effective heat dissipation for the chip packaging unit 120 and the plurality of groups of first conductive modules 130. The thermally conductive adhesive 140 is flush with the bottommost film layer in the plurality of groups of first conductive modules 130, so that the multi-layer board-type chip-embedded circuit board has a flat lower surface, for assembly with other circuit modules of the inverter.

In some embodiments, the slot of the plurality of groups of first conductive modules 130 is connected to a cooling apparatus, the cooling apparatus seals the heat dissipation cavity 136, and the auxiliary heat dissipation material is cooling oil 150 that circulates and fills the heat dissipation cavity 136, which is specifically shown in FIG. 2. By continuously circulating the cooling oil 150, the heat generated during the operation of the chip packaging unit 120 and the first conductive modules 130 can be quickly taken away, thereby achieving effective heat dissipation and achieving insulation protection for the chip packaging unit 120 and the first conductive modules 130.

In the above-mentioned embodiments, heat dissipation fins 122 may be provided on the back surface of the chip packaging unit 120, and the auxiliary heat dissipation material fills a gap between the heat dissipation fins 122. The heat dissipation fins 122 may increase a heat dissipation area and improve heat dissipation performance of the chip packaging unit 120. High-efficiency heat dissipation is achieved through the cooperation of the auxiliary heat dissipation material and the heat dissipation fins 122.

In some embodiments, the plurality of groups of first conductive modules 130 include two groups, where each group of first conductive modules 130 includes a first dielectric layer 131 and a first conductive layer 132, and first dielectric layers 131 and first conductive layers 132 in the two groups of first conductive modules 130 are alternately stacked.

The first dielectric layer 131 provides insulation protection and enables the first conductive layer 132 to be adhered stably. The first conductive layer 132 may stabilize signal transmission and improve the signal transmission capability of the circuit board. A thickness of each group of first conductive modules 130 may be set as required, for example, to about 1mm, which is not limited thereto.

In some embodiments, the multi-layer board-type chip-embedded circuit board further includes a plurality of groups of second conductive modules 160 stacked above the prefabricated circuit board 110, where each group of second conductive modules 160 includes a second dielectric layer 161 and a second conductive layer 162, and second dielectric layers 161 and second conductive layers 162 in the plurality of groups of second conductive modules 160 are alternately stacked; and electrode lead-out wires 170 led out from a front side of the chip packaging unit 120 to a surface of the plurality of groups of second conductive modules 160, the electrode lead-out wires 170 including vertical strip-shaped lead-out wires formed in the second dielectric layer 161 and horizontal strip-shaped lead-out wires formed in the second conductive layer 162, where each electrode of the chip packaging unit 120 is led out through at least one vertical strip-shaped lead-out wire, and each horizontal strip-shaped lead-out wire is connected to vertical strip-shaped lead-out wires that lead out one or more electrodes.

According to the present disclosure, by separately stacking the plurality of groups of conductive modules above and below the prefabricated circuit board 110, the multi-layer board-type chip-embedded circuit board is formed, which is specifically a six-layer board-type (referring to six conductive layers, including two second conductive layers 162, an upper conductive layer 111 and a lower conductive layer 111 of the prefabricated circuit board 110, and two first conductive layers 132) chip-embedded circuit board shown in FIG. 1 and FIG. 2. The mechanical strength, signal transmission capability, and drive stability of the six-layer board-type chip-embedded circuit board make it possible to achieve strict compatibility with and adaptability to a vehicle inverter, making it applicable to scenarios that require strict compatibility with and adaptability to a drive/control module of the inverter.

A source and a drain of the chip packaging unit 120 may be led out respectively through a plurality of vertical strip-shaped lead-out wires, to ensure stable connection and signal transmission, and to adapt to the large current operating conditions of the inverter. The horizontal strip-shaped lead-out wire is connected to the vertical strip-shaped lead-out wires that lead out one or more electrodes, which not only facilitates the lead-out of the electrode lead-out wires 170 to the surface of the plurality of groups of second conductive modules 160, ensuring stable connection of the electrode lead-out wires 170 between the layers of the circuit board and avoiding disconnection, but also achieves the connection between electrodes of different chip packaging units 120, to adapt to working requirements of a power module of the inverter.

Specifically, in some embodiments, the plurality of groups of second conductive modules 160 include two groups, and two chip packaging units 120 are embedded at an interval in the prefabricated circuit board 110, where a drain of the first chip packaging unit 120 is led out sequentially through a group of vertical strip-shaped lead-out wires 170a1 located in a lower second dielectric layer 161, a horizontal strip-shaped lead-out wire 170a2 located in the lower second conductive layer 162, a group of vertical strip-shaped lead-out wires 170a3 located in an upper second dielectric layer 161, and a horizontal strip-shaped lead-out wire 170a4 located in the upper second conductive layer 162; a gate of the first chip packaging unit 120 is led out through a vertical strip-shaped lead-out wire 170b that passes through the lower second dielectric layer 161, the lower second conductive layer 162, the upper second dielectric layer 161, and the upper second conductive layer 162; a source of the first chip packaging unit 120 is led out through a group of vertical strip-shaped lead-out wires 170c1 located in the lower second dielectric layer 161, a drain of the second chip packaging unit 120 is led out through a group of vertical strip-shaped lead-out wires 170c2 located in the lower second dielectric layer 161, the vertical strip-shaped lead-out wires 170c1 leading out the source of the first chip packaging unit 120 and the vertical strip-shaped lead-out wires 170c2 leading out the drain of the second chip packaging unit 120 are connected through a horizontal strip-shaped lead-out wire 170c3 located in the lower second conductive layer 162, and are led out through a group of vertical strip-shaped lead-out wires 170c4 located in the upper second dielectric layer 161 and a horizontal strip-shaped lead-out wire 170c5 located in the upper second conductive layer 162; a source of the second chip packaging unit 120 is led out sequentially through a group of vertical strip-shaped lead-out wires 170d1 located in the lower second dielectric layer 161, a horizontal strip-shaped lead-out wire 170d2 located in the lower second conductive layer 162, a group of vertical strip-shaped lead-out wires 170d3 located in the upper second dielectric layer 161, and a horizontal strip-shaped lead-out wire 170d4 located in the upper second conductive layer 162; and a gate of the second chip packaging unit 120 is led out through a vertical strip-shaped lead-out wire 170e that passes through the lower second dielectric layer 161, the lower second conductive layer 162, the upper second dielectric layer 161, and the upper second conductive layer 162.

Among all conductive layers, the lower second conductive layer 162 has a largest thickness, to ensure that the horizontal strip-shaped lead-out wire 170a2, the horizontal strip-shaped lead-out wire 170c3, and the horizontal strip-shaped lead-out wire 170d2 have sufficient strength, so that the connection of the electrode lead-out wires 170 between the layers of the circuit board is stable and disconnection is avoided, and to achieve stable connection between the electrodes of different chip packaging units 120 according to the working requirements of the power module of the inverter.

Further, the horizontal strip-shaped lead-out wire 170a4, the vertical strip-shaped lead-out wire 170b, the horizontal strip-shaped lead-out wire 170c5, the horizontal strip-shaped lead-out wire 170d4, and the vertical strip-shaped lead-out wire 170e that are led out to the surface of the upper second conductive layer 162 may be connected to other electronic components of the inverter through pads. The horizontal strip-shaped lead-out wire 170a4 is connected to a positive electrode of a direct-current power source, the vertical strip-shaped lead-out wire 170b is connected to the control circuit, the horizontal strip-shaped lead-out wire 170c5 is connected to a load motor, the horizontal strip-shaped lead-out wire 170d4 is connected to a negative electrode of the direct-current power source, and the vertical strip-shaped lead-out wire 170e is connected to the control circuit.

Embodiments of the present disclosure further provide a manufacturing method for a multi-layer board-type chip-embedded circuit board, which is used for manufacturing a multi-layer board-type chip-embedded circuit board according to any one of the above embodiments. The features and principles of the multi-layer board-type chip-embedded circuit board according to the above embodiments can all be applied to the following embodiments of the manufacturing method. In the following embodiments of the manufacturing method, the features and principles of the multi-layer board-type chip-embedded circuit board that have been described will not be repeated.

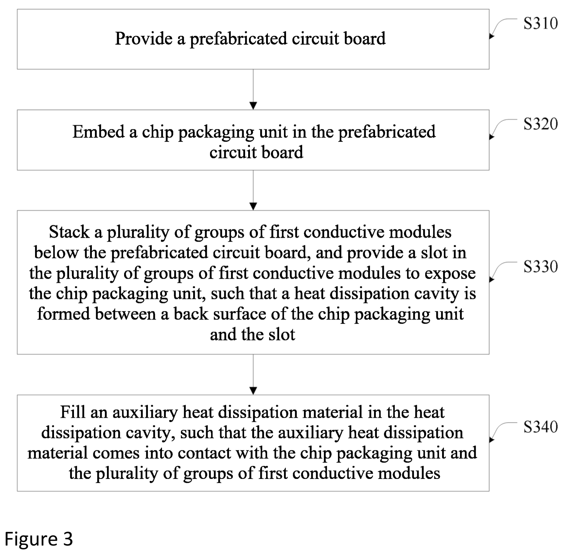

FIG. 3 illustrates main steps of a manufacturing method for a multi-layer board-type chip-embedded circuit board. Referring to FIG. 3 and in combination with FIG. 1 and FIG. 2, the manufacturing method for a multi-layer board-type chip-embedded circuit board according to an embodiment of the present disclosure includes the following steps:
S310: Provide a prefabricated circuit board 110.
S320: Embed a chip packaging unit 120 in the prefabricated circuit board 110.
S330: Stack a plurality of groups of first conductive modules 130 below the prefabricated circuit board 110, and provide a slot in the plurality of groups of first conductive modules 130 to expose the chip packaging unit 120, such that a heat dissipation cavity 136 is formed between a back surface of the chip packaging unit 120 and the slot.
S340: Fill an auxiliary heat dissipation material in the heat dissipation cavity 136, such that the auxiliary heat dissipation material comes into contact with the chip packaging unit 120 and the plurality of groups of first conductive modules 130.

The multi-layer board-type chip-embedded circuit board that is manufactured and formed greatly enhances the signal transmission capability of the circuit board through the plurality of groups of first conductive modules 130, thereby ensuring the stable operation of the circuit board and stable transmission of electrical signals; and the plurality of groups of first conductive modules 130 can also enhance the structural strength of the circuit board, prolong the service life of the circuit board, so that the circuit board adapts to the usage scenarios of a vehicle inverter. In addition, heat generated during the operation of the chip packaging unit 120 and the first conductive modules 130 is quickly taken away by means of the auxiliary heat dissipation material filled in the heat dissipation cavity 136, thereby achieving effective heat dissipation, so that the circuit board adapts to large current operating conditions of an inverter and is applicable to usage scenarios that require strict compatibility with/adaptability to the inverter.

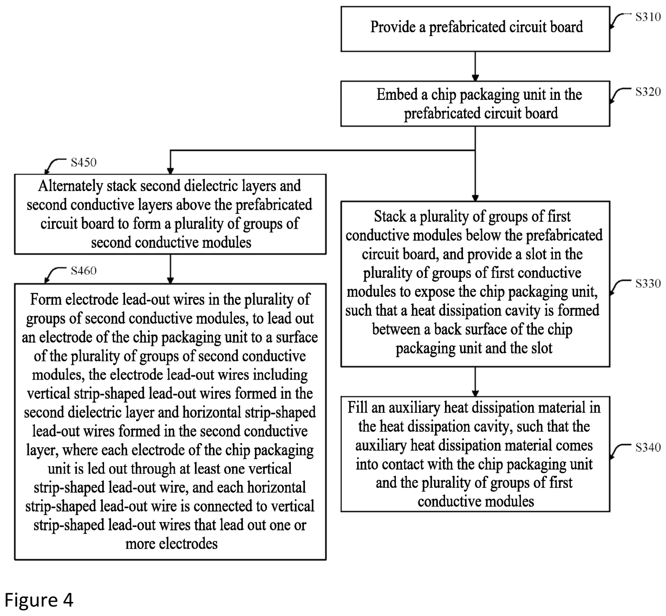

FIG. 4 illustrates main steps of another manufacturing method for a multi-layer board-type chip-embedded circuit board. Referring to FIG. 4 and in combination with FIG. 1 to FIG. 3, in some embodiments, the manufacturing method for a multi-layer board-type chip-embedded circuit board further includes the following steps:
S450: Alternately stack second dielectric layers 161 and second conductive layers 162 above the prefabricated circuit board 110 to form a plurality of groups of second conductive modules 160.
S460: Form electrode lead-out wires 170 in the plurality of groups of second conductive modules 160, to lead out an electrode of the chip packaging unit 120 to a surface of the plurality of groups of second conductive modules 160, the electrode lead-out wires 170 including vertical strip-shaped lead-out wires formed in the second dielectric layer 161 and horizontal strip-shaped lead-out wires formed in the second conductive layer 162, where each electrode of the chip packaging unit 120 is led out through at least one vertical strip-shaped lead-out wire, and each horizontal strip-shaped lead-out wire is connected to vertical strip-shaped lead-out wires that lead out one or more electrodes.

A source and a drain of the chip packaging unit 120 may be led out respectively through a plurality of vertical strip-shaped lead-out wires, to ensure stable connection and signal transmission, and to adapt to the large current operating conditions of the inverter. The horizontal strip-shaped lead-out wire is connected to the vertical strip-shaped lead-out wires that lead out one or more electrodes, which not only facilitates the lead-out of the electrode lead-out wires 170 to the surface of the plurality of groups of second conductive modules 160, ensuring stable connection of the electrode lead-out wires 170 between the layers of the circuit board and avoiding disconnection, but also achieves the connection between electrodes of different chip packaging units 120, to adapt to working requirements of a power module of the inverter.

According to the present disclosure, by separately stacking the plurality of groups of conductive modules above and below the prefabricated circuit board 110, a six-layer board-type chip-embedded circuit board is formed, whose mechanical strength, signal transmission capability, and drive stability make it possible to achieve strict compatibility with and adaptability to an inverter, making it applicable to usage scenarios that require strict compatibility with and adaptability to a drive/control module of the inverter.

The above is a further detailed description of the present disclosure with reference to the specific preferred implementations, and it cannot be considered that the specific implementation of the present disclosure is limited to these descriptions. For those of ordinary skill in the art of the present disclosure, several simple deductions or substitutions can be further made without departing from the concept of the present disclosure, and should be regarded as falling within the scope of protection of the present disclosure.

## Claims

1. A multi-layer board-type chip-embedded circuit board, the multi-layer circuit board comprising:
a prefabricated circuit board;
a chip packaging unit embedded in the prefabricated circuit board; and
a plurality of groups of first conductive modules stacked below the prefabricated circuit board, the plurality of groups of first conductive modules being provided with a slot from which the chip packaging unit is exposed, such that a heat dissipation cavity is formed between a back surface of the chip packaging unit and the slot, and the heat dissipation cavity is filled with an auxiliary heat dissipation material that is in contact with the chip packaging unit and the plurality of groups of first conductive modules.

2. The multi-layer board-type chip-embedded circuit board according to claim 1, wherein the auxiliary heat dissipation material is a thermally conductive adhesive, and the thermally conductive adhesive is flush with a bottommost film layer in the plurality of groups of first conductive modules.

3. The multi-layer board-type chip-embedded circuit board according to claim 1, wherein the slot is connected to a cooling apparatus, the cooling apparatus seals the heat dissipation cavity, and the auxiliary heat dissipation material is cooling oil that circulates and fills the heat dissipation cavity.

4. The multi-layer board-type chip-embedded circuit board according to any one of claims 1 to 3, wherein heat dissipation fins are provided on the back surface of the chip packaging unit, and the auxiliary heat dissipation material fills a gap between the heat dissipation fins.

5. The multi-layer board-type chip-embedded circuit board according to claim 1, wherein the plurality of groups of first conductive modules comprise two groups, wherein each group of first conductive modules comprises a first dielectric layer and a first conductive layer, and first dielectric layers and first conductive layers in the two groups of first conductive modules are alternately stacked.

6. The multi-layer board-type chip-embedded circuit board according to claim 1, the multi-layer circuit board further comprising:
a plurality of groups of second conductive modules stacked above the prefabricated circuit board, wherein each group of second conductive modules comprises a second dielectric layer and a second conductive layer, and second dielectric layers and second conductive layers in the plurality of groups of second conductive modules are alternately stacked; and
electrode lead-out wires led out from a front side of the chip packaging unit to a surface of the plurality of groups of second conductive modules, the electrode lead-out wires comprising vertical strip-shaped lead-out wires formed in the second dielectric layer and horizontal strip-shaped lead-out wires formed in the second conductive layer, wherein each electrode of the chip packaging unit is led out through at least one vertical strip-shaped lead-out wire, and each horizontal strip-shaped lead-out wire is connected to vertical strip-shaped lead-out wires that lead out one or more electrodes.

7. The multi-layer board-type chip-embedded circuit board according to claim 6, wherein the plurality of groups of second conductive modules comprise two groups, and two chip packaging units are embedded at an interval in the prefabricated circuit board, wherein
a drain of a first chip packaging unit is led out sequentially through a group of vertical strip-shaped lead-out wires located in a lower second dielectric layer, a horizontal strip-shaped lead-out wire located in the lower second conductive layer, a group of vertical strip-shaped lead-out wires located in an upper second dielectric layer, and a horizontal strip-shaped lead-out wire located in the upper second conductive layer;
a gate of the first chip packaging unit is led out through a vertical strip-shaped lead-out wire that passes through the lower second dielectric layer, the lower second conductive layer, the upper second dielectric layer, and the upper second conductive layer;
a source of the first chip packaging unit is led out through a group of vertical strip-shaped lead-out wires located in the lower second dielectric layer, a drain of a second chip packaging unit is led out through a group of vertical strip-shaped lead-out wires located in the lower second dielectric layer, the vertical strip-shaped lead-out wires leading out the source of the first chip packaging unit and the vertical strip-shaped lead-out wires leading out the drain of the second chip packaging unit are connected through a horizontal strip-shaped lead-out wire located in the lower second conductive layer, and are led out through a group of vertical strip-shaped lead-out wires located in the upper second dielectric layer and a horizontal strip-shaped lead-out wire located in the upper second conductive layer;
a source of the second chip packaging unit is led out sequentially through a group of vertical strip-shaped lead-out wires located in the lower second dielectric layer, a horizontal strip-shaped lead-out wire located in the lower second conductive layer, a group of vertical strip-shaped lead-out wires located in the upper second dielectric layer, and a horizontal strip-shaped lead-out wire located in the upper second conductive layer; and
a gate of the second chip packaging unit is led out through a vertical strip-shaped lead-out wire that passes through the lower second dielectric layer, the lower second conductive layer, the upper second dielectric layer, and the upper second conductive layer.

8. The multi-layer board-type chip-embedded circuit board according to claim 7, wherein among all conductive layers, the lower second conductive layer has a largest thickness.

9. A manufacturing method for a multi-layer board-type chip-embedded circuit board, which is used for manufacturing a multi-layer board-type chip-embedded circuit board according to any one of claims 1 to 8, the manufacturing method comprising:
providing a prefabricated circuit board;
embedding a chip packaging unit in the prefabricated circuit board;
stacking a plurality of groups of first conductive modules below the prefabricated circuit board, and providing a slot in the plurality of groups of first conductive modules to expose the chip packaging unit, such that a heat dissipation cavity is formed between a back surface of the chip packaging unit and the slot; and
filling an auxiliary heat dissipation material in the heat dissipation cavity, such that the auxiliary heat dissipation material comes into contact with the chip packaging unit and the plurality of groups of first conductive modules.

10. The manufacturing method according to claim 9, further comprising:
alternately stacking second dielectric layers and second conductive layers above the prefabricated circuit board to form a plurality of groups of second conductive modules; and forming electrode lead-out wires in the plurality of groups of second conductive modules, to lead out an electrode of the chip packaging unit to a surface of the plurality of groups of second conductive modules, the electrode lead-out wires comprising vertical strip-shaped lead-out wires formed in the second dielectric layer and horizontal strip-shaped lead-out wires formed in the second conductive layer, wherein each electrode of the chip packaging unit is led out through at least one vertical strip-shaped lead-out wire, and each horizontal strip-shaped lead-out wire is connected to vertical strip-shaped lead-out wires that lead out one or more electrodes.
